# EUROPEAN PATENT APPLICATION

(11) **EP 4 831 738 A1**
(43) Date of publication of application: **28.10.2026**
(21) Application number: 23962154.3
(22) Date of filing: 19.12.2023
(51) Int. Cl.: G03F 7/031, G03F 7/004

(54) **PHOTOSENSITIVE COMPOSITION, PHOTOSENSITIVE ELEMENT, METHOD FOR FORMING RESIST PATTERN, AND METHOD FOR MANUFACTURING PRINTED WIRING BOARD**

(71) Applicant: Resonac Corporation, Tokyo 105-7325 (JP)
(72) Inventor: KURODA, Naoto, Tokyo 105-7325 (JP); MIYASAKA, Masahiro, Tokyo 105-7325 (JP)
(74) Representative: Hoffmann Eitle
(86) International application number: PCT/JP2023/045515
(87) International publication number: WO 2025/134231

(57) **Abstract**

Provided is a photosensitive composition, a photosensitive element, a method of forming a resist pattern, and a method of manufacturing a printed circuit board that enable halogen-free implementation. A photosensitive composition includes: a binder polymer (A); a photopolymerizable compound (B); and a hexaarylbiimidazole compound (C1) having no halogen atom in its molecular structure.

## Description

### TECHNICAL FIELD

The present disclosure relates to a photosensitive composition, a photosensitive element, a method of forming resist pattern, and a method of manufacturing a printed circuit board.

### BACKGROUND ART

In the field of printed circuit board manufacturing, photosensitive resin materials are widely used as resist materials for etching and plating processes. Photosensitive resin materials are mainly distributed in the market as photosensitive elements in the form of a laminated film where a photosensitive layer which is liquid, or includes a photosensitive resin material, is formed on a support, and a protective film is arranged thereon.

Recently, circuit patterns are becoming finer, and development of photosensitive resin materials that can cope with this trend is required. Basic and important performance requirements for photosensitive resin materials include sufficient photosensitivity with a minimal amount of light irradiation, and an ability to develop at high resolution. In addition, reduction of environmental load and improvement of safety of working environment are strongly required for industrial chemical products, and development of products that do not include halogen atoms is expected as one such product.

Hexaarylbiimidazole compounds having chloro groups are widely used as polymerization initiators included in photosensitive resin materials. However, there is a concern about environmental loads of these compounds because they include halogen atoms. In addition, performance as polymerization initiators was not sufficient under the condition that circuit patterns were becoming finer (see Patent Literature 1).

### CITATION LIST

### PATENT LITERATURE

Patent Literature 1: JP H5-27436 A

### SUMMARY OF INVENTION

### TECHNICAL PROBLEM

An object of the present disclosure is to provide a photosensitive composition, a photosensitive element, a method of forming a resist pattern, and a method of manufacturing a printed circuit board that enable halogen-free implementation.

### SOLUTION TO PROBLEM

The present disclosure includes the following embodiments. The present disclosure is not limited to the following embodiments.

An embodiment relates to a photosensitive composition including a binder polymer (A), a photopolymerizable compound (B), and a hexaarylbiimidazole compound (C1) including no halogen atom in its molecular structure.

Another embodiment relates to a photosensitive composition including a binder polymer (A), a photopolymerizable compound (B), and a hexaarylbiimidazole compound (C2) represented by general formula (1) below.

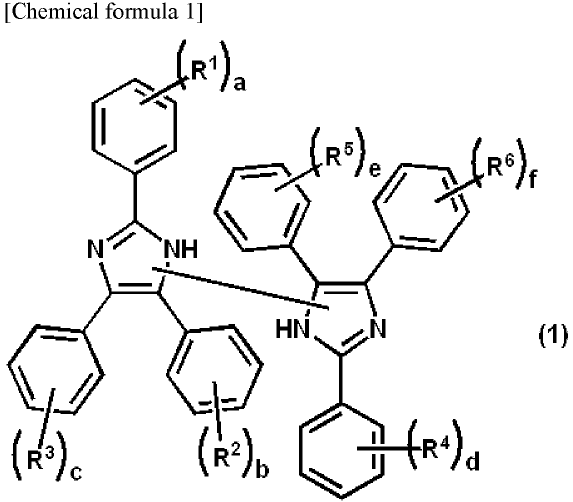

In general formula (1), R¹ to R⁶ are each independently an alkyl group or an alkoxy group, and a to f are each independently an integer from 0 to 5. When a to f are integers of 2 or more, multiple R^{X} (X is any one of 1 to 6) in the formula may all be different from each other, or may be partially or entirely the same. At least one of a, b, c, d, e, or f is an integer of 1 or more, and at least one of R¹, R², R³, R⁴, R⁵, or R⁶ present in the formula is an alkoxy group.

### EFFECTS OF INVENTION

The present disclosure can provide a photosensitive composition, a photosensitive element, a method of forming a resist pattern, and a method of manufacturing a printed circuit board that enable halogen-free implementation.

### DESCRIPTION OF EMBODIMENTS

Embodiments of the present disclosure will be described below. However, the present disclosure is not limited to the following embodiments.

Note that a numerical range indicated using "to" in the present disclosure means a range that includes numerical values described before and after "to" as the minimum and maximum values, respectively.

In numerical ranges described step by step in the present disclosure, an upper or lower limit of a numerical range may be replaced with an upper or lower limit of another numerical range. An upper or lower limit of a numerical range described in the present disclosure may be replaced with a value indicated in examples.

Unless otherwise specified, a photosensitive composition according to the present disclosure may include one or more substances corresponding to each component.

In the present disclosure, when the photosensitive composition includes multiple substances corresponding to a certain component, the content of the component in the photosensitive composition means, unless otherwise specified, the total amount of the multiple substances present in the photosensitive composition.

In the present disclosure, (meth)acrylic acid means at least one of acrylic acid or methacrylic acid. A (meth)acrylate means at least one of an acrylate or a corresponding methacrylate. A (meth)acryloyl group means at least one of an acryloyl group or a methacryloyl group.

In this disclosure, unless otherwise specified, weight-average molecular weight (Mw) and number-average molecular weight (Mn) are values obtained using gel permeation chromatography (GPC) and converted from a calibration curve using standard polystyrene. Conditions of GPC are as follows.

| | |
|---|---|
| Detector: | L-2490 type RI (Hitachi High-Tech Corporation) |
| Columns: | Gelpack GL-R440, Gelpack GL-R450, and Gelpack GL-R400M (Resonac Techno Service Corporation) |
| Eluent: | tetrahydrofuran |
| Sample concentration: | 5 mg / 1 mL |
| Injection volume: | 200 µL |
| Flow rate: | 2.05 mL/min |
| Measurement temperature: | 40°C |

A photosensitive composition according to an embodiment of the present disclosure includes a binder polymer (A), a photopolymerizable compound (B), and a hexaarylbiimidazole compound (C1) including no halogen atom in its molecular structure.

A photosensitive composition according to another embodiment of the present disclosure includes the binder polymer (A), the photopolymerizable compound (B), and a hexaarylbiimidazole compound (C2) represented by general formula (1) below.

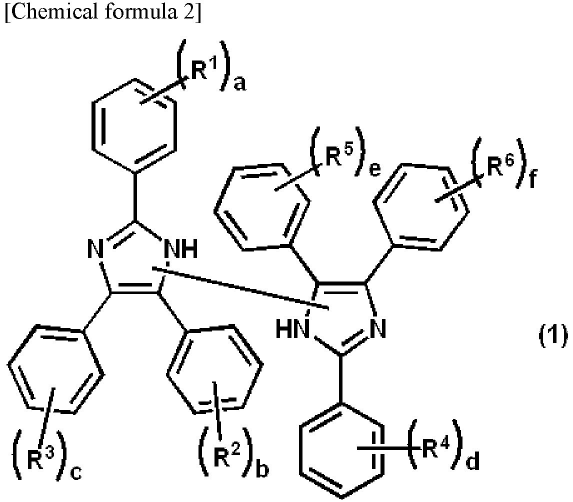

In general formula (1), R¹ to R⁶ are each independently an alkyl group or an alkoxy group, and a to f are each independently an integer from 0 to 5. When a to f are integers of 2 or more, multiple R^{X} (X is any one of 1 to 6) in the formula may all be different from each other, or may be partially or entirely the same. At least one of a, b, c, d, e, or f is an integer of 1 or more, and at least one of R¹, R², R³, R⁴, R⁵, or R⁶ present in the formula is an alkoxy group.

In a photosensitive composition according to an embodiment, the hexaarylbiimidazole compound (C1) including no halogen atom in its molecular structure (hereinafter sometimes referred to as "hexaarylbiimidazole compound (C1)") is a component that produces a hydrogen abstraction-type radical upon irradiation with light, and can function as a photopolymerization initiator. The photosensitive composition can be used for a photosensitive element, such as a negative-type resist material, for example. The photosensitive composition has excellent photosensitivity and developability by including the hexaarylbiimidazole compound (C1) as a photopolymerization initiator.

In a photosensitive composition according to an embodiment, the hexaarylbiimidazole compound (C2) is a component that produces a hydrogen abstraction-type radical upon irradiation with light, and can function as a photopolymerization initiator. The photosensitive composition can be used for a photosensitive element, such as a negative-type resist material, for example. The photosensitive composition has excellent photosensitivity and developability by including the hexaarylbiimidazole compound (C2) as a photopolymerization initiator.

### [Binder polymer (A)]

One type of binder polymer (A) may be used singly, or two or more types may be used in combination. From the viewpoint of halogen-free implementation, it is preferable that the binder polymer (A) include no halogen atom in its molecular structure. Note that "including no halogen atom in its molecular structure" herein means including no halogen atom in its molecular structure theoretically, in addition to having an amount of a halogen atom below a detection limit when actually analyzed, and does not exclude including an extremely small amount of a halogen atom due to industrial manufacturing reasons, for example.

The binder polymer (A) preferably has a weight-average molecular weight (Mw) of 5,000 or more, more preferably 10,000 or more, and particularly preferably 20,000 or more, as this provides a photosensitive composition with high resolution. The binder polymer (A) preferably has a weight-average molecular weight (Mw) of 150,000 or less, more preferably 100,000 or less, and particularly preferably 50,000 or less, as this provides a photosensitive composition with excellent developability. The weight-average molecular weight (Mw) of the binder polymer (A) may be, for example, within a range from 5,000 to 150,000. A dispersity (Mw/Mn) of the binder polymer (A) is not particularly limited, and may be, for example, 1.0 or more, and may be 3.0 or less.

The binder polymer (A) preferably includes no photopolymerizable group as this provides a photosensitive composition with excellent developability and resolution. When the photosensitive composition is used for alkali development, it is preferable that the binder polymer (A) include an acid group, such as a carboxy group, as this provides a photosensitive composition with excellent alkali developability. The acid value of the binder polymer (A) may be, for example, 80 mgKOH/g or more, 100 mgKOH/g or more, or 150 mgKOH/g or more. The acid value of the binder polymer (A) may be, for example, 250 mg KOH/g or less, 220 mg KOH/g or less, or 210 mg KOH/g or less.

In the present disclosure, the acid value of the binder polymer (A) is a value measured using the following method. First, 30 g of acetone is added to 1 g of the binder polymer (A), which is to be measured for the acid value, and the mixture is homogeneously dissolved. Then, an appropriate amount of phenolphthalein as an indicator is added to the acetone solution of the binder polymer (A), and the mixture is titrated using a 0.1 N aqueous potassium hydroxide (KOH) solution. The acid value can be calculated from the amount of the aqueous potassium hydroxide (KOH) solution required to neutralize the acetone solution of the binder polymer (A).

An example of the binder polymer (A) is an acrylic resin (A1) having an acid group (hereinafter, this may be referred to as "acrylic resin (A1)"). Examples of the acrylic resin (A1) include those having polymerizable monomers having acid groups, such as (meth)acrylic acid, as constituent units.

In addition to a polymerizable monomer having an acid group, the acrylic resin (A1) may include another polymerizable monomer as a constituent unit. Examples of the other polymerizable monomer include: acrylic acid alkyl esters such as methyl (meth)acrylates, ethyl (meth)acrylates, propyl (meth)acrylates, butyl (meth)acrylates, and 2-ethylhexyl (meth)acrylates; hydroxyl group-containing (meth)acrylates such as hydroxymethyl (meth)acrylates, hydroxyethyl (meth)acrylates, hydroxypropyl (meth)acrylates, and hydroxybutyl (meth)acrylates; alicyclic (meth)acrylates such as cyclohexyl (meth)acrylates, isoboronyl (meth)acrylates, dicyclopentanyl (meth)acrylates, and dicyclopentenyl (meth)acrylates; aromatic ring-containing (meth)acrylates such as phenyl (meth)acrylates, benzyl (meth)acrylates, and phenoxyethyl (meth)acrylates; and styrene compounds such as styrene and α-methylstyrene. These may each be used singly, or two or more types may be used in combination.

An example of the acrylic resin (A1) is one having a divalent group represented by general formula (2) below.

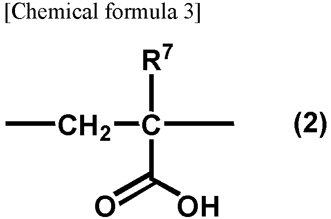

In formula (2), R⁷ is a hydrogen atom or a methyl group.

The proportion of the divalent group represented by general formula (2) in the acrylic resin (A1) is suitably adjusted according to a desired acid group of the acrylic resin (A1), and may be, for example, 10% by mass or more, 15% by mass or more, or 20% by mass or more. It may be 50% by mass or less, 40% by mass or less, or 35% by mass or less. The proportion of the divalent group represented by general formula (2) in the acrylic resin (A1) may be, for example, within a range from 10% to 50% by mass.

In addition to the divalent group represented by general formula (2), the acrylic resin (A1) may have one or more divalent groups represented by any one of general formulas (3) to (5) below.

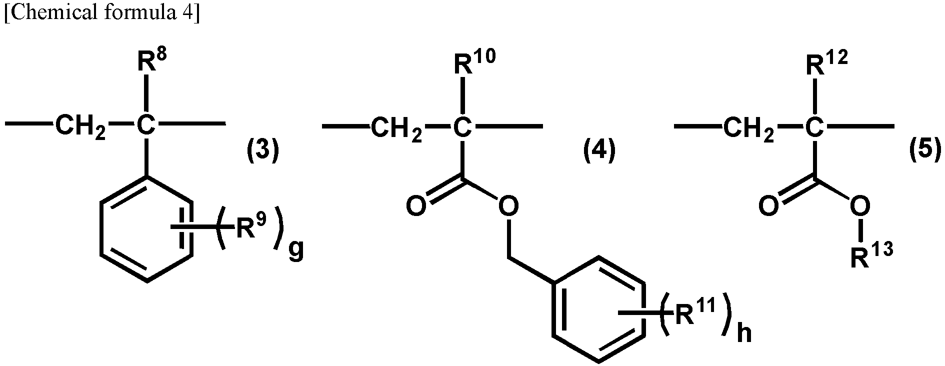

**In** general formula (3), R⁸ is a hydrogen atom or a methyl group. R⁹ is an alkyl group having 1 to 3 carbon atoms, an alkoxy group having 1 to 3 carbon atoms, or a hydroxyl group, and g is an integer from 0 to 5. When g is 2 or more, multiple R⁹ groups in the formula may all be different from each other, or may be partially or entirely the same.

**In** general formula (4), R¹⁰ is a hydrogen atom or a methyl group. R¹¹ is an alkyl group having 1 to 3 carbon atoms, an alkoxy group having 1 to 3 carbon atoms, or a hydroxyl group, and h is an integer from 0 to 5. When h is 2 or more, multiple R¹¹ groups present in the formula may all be different from each other, or may be partially or wholly the same.

In general formula (5), R¹² is a hydrogen atom or a methyl group. R¹³ is an alkyl group having 1 to 4 carbon atoms, or a hydroxyalkyl group having 1 to 4 carbon atoms.

R⁹ in general formula (3) and R¹¹ in general formula (4) are each an alkyl group having 1 to 3 carbon atoms, an alkoxy group having 1 to 3 carbon atoms, or a hydroxyl group. The alkyl group having 1 to 3 carbon atoms is specifically a methyl group, an ethyl group, an n-propyl group, or an isopropyl group. The alkoxy group having 1 to 3 carbon atoms is specifically a methoxy group, an ethoxy group, an n-propyloxy group, or an isopropyloxy group. g in general formula (3) and h in general formula (4) are each an integer from 0 to 5. For example, g and h may each be 0 or 1, or may both be 0.

R¹³ in general formula (5) is an alkyl group having 1 to 4 carbon atoms or a hydroxyalkyl group having 1 to 4 carbon atoms. The alkyl group having 1 to 4 carbon atoms is specifically a methyl group, an ethyl group, an n-propyl group, an isopropyl group, an n-butyl group, a t-butyl group, an s-butyl group, or an isobutyl group. The hydroxyalkyl group having 1 to 4 carbon atoms is specifically obtained by substituting one or more hydrogen atoms in the alkyl group having 1 to 4 carbon atoms with a hydroxy group, and examples thereof include a hydroxymethyl group, a hydroxyethyl group, a hydroxypropyl group, and a hydroxybutyl group.

The proportion of the divalent group represented by general formula (2) in the acrylic resin (A1) is suitably adjusted according to a desired acid group of the acrylic resin (A1), and may be, for example, 10% by mass or more, 15% by mass or more, or 20% by mass or more. It may be 50% by mass or less, 40% by mass or less, or 35% by mass or less. The proportion of the divalent group represented by general formula (2) in the acrylic resin (A1) may be, for example, within a range from 10% to 50% by mass.

In the acrylic resin (A1), the proportion of the divalent group represented by general formula (3) may be, for example, 10% by mass or more, 20% by mass or more, or 35% by mass or more. It may be 65% by mass or less, 55% by mass or less, or 50% by mass or less. In the acrylic resin (A1), the proportion of the divalent group represented by general formula (3) may be, for example, within a range from 10% to 65% by mass.

In the acrylic resin (A1), the proportion of the divalent group represented by general formula (4) may be, for example, 5% by mass or more, 10% by mass or more, or 15% by mass or more. It may be 50% by mass or less, 40% by mass or less, or 30% by mass or less. In the acrylic resin (A1), the proportion of the divalent group represented by general formula (2) may be, for example, within a range from 5% to 50% by mass.

In the acrylic resin (A1), the proportion of the divalent group represented by general formula (5) may be, for example, 0.1% by mass or more, 0.5% by mass or more, or 1% by mass or more. It may be 30% by mass or less, 20% by mass or less, or 15% by mass or less. The proportion of the divalent group represented by general formula (2) in the acrylic resin (A1) may be, for example, within a range from 0.1% to 30% by mass.

The total proportion of the divalent group represented by any one of general formulas (2) to (5) in the acrylic resin (A1) may be, for example, 50% by mass or more, 70% by mass or more, 90% by mass or more, or 100% by mass.

The proportion of the acrylic resin (A1) to the total amount of the binder polymer (A) may be, for example, 50% by mass or more, 70% by mass or more, 90% by mass or more, or 100% by mass.

### [Photopolymerizable compound (B)]

One type of the photopolymerizable compound (B) may be used singly, or two or more types thereof may be used in combination. From the viewpoint of halogen-free implementation, it is preferable that the photopolymerizable compound (B) include no halogen atom in its molecular structure. Note that "including no halogen atom in its molecular structure" as used herein includes including no halogen atom in its molecular structure in theory, in addition to having the amount of a halogen atom below a detection limit when actually analyzed, and does not exclude including an extremely small amount of a halogen atom due to industrial manufacturing reasons, for example.

The photopolymerizable compound (B) preferably has a molecular weight of 4,000 or less, as this provides a photosensitive composition with high sensitivity and resolution. The molecular weight of the photopolymerizable compound (B) may be 3,000 or less, or 2,000 or less. The molecular weight of the photopolymerizable compound (B) may be 100 or more, 200 or more, or 500 or more. The molecular weight of the photopolymerizable compound (B) may be, for example, within a range from 100 to 4,000.

Specifically, the photopolymerizable compound (B) may be a compound having a photopolymerizable group such as a (meth)acryloyl group, or a vinyl group. Examples of the photopolymerizable compound (B) include a monofunctional photopolymerizable compound having one photopolymerizable group per molecule (hereinafter sometimes referred to as a "monofunctional compound (B1)"), a bifunctional photopolymerizable compound having two photopolymerizable groups per molecule (hereinafter sometimes referred to as a "bifunctional compound (B2)"), and a polyfunctional photopolymerizable compound having three or more photopolymerizable groups per molecule (hereinafter sometimes referred to as a "polyfunctional compound (B3)").

Examples of the monofunctional compound (B1) include: alkyl (meth)acrylates such as methyl (meth)acrylates, ethyl (meth)acrylates, and propyl (meth)acrylates; (meth)acrylates including an alicyclic structure such as dicyclopentenyl (meth)acrylates and dicyclopentanyl (meth)acrylates; (meth)acrylates including an aromatic structure such as benzyl (meth)acrylates and nonylphenoxy (meth)acrylates; (meth)acrylates including a heterocyclic structure such as tetramethylpiperidyl (meth)acrylates and pentamethylpiperidyl (meth)acrylates; and (poly)alkylene oxide-modified compounds thereof; and phthalate compounds such as γ-chloro-β-hydroxyalkyl-β'-(meth)acryloyloxyalkyl phthalate, and β-hydroxyalkyl-β'-(meth)acryloyloxyalkyl phthalate.

Examples of the bifunctional compound (B2) include: di(meth)acrylates of aliphatic polyol, and (poly)alkylene oxide-modified compounds thereof; di(meth)acrylates of bisphenol, and (poly)alkylene oxide-modified compounds thereof; di(meth)acrylates of bifunctional epoxy compounds, and (poly)alkylene oxide-modified compounds thereof; polyalkylene glycol di(meth)acrylates; and urethane di(meth)acrylates.

Regarding di(meth)acrylates of aliphatic polyol, examples of aliphatic polyol include ethylene glycol, propylene glycol, butanediol, hexanediol, neopentyl glycol, trimethylolethane, trimethylolpropane, and glycerin.

Regarding di(meth)acrylates of bisphenol, it is preferable that bisphenol include no halogen atom in its molecular structure, and examples thereof include bisphenol A, bisphenol AP, bisphenol B, bisphenol BP, bisphenol C, bisphenol E, and bisphenol F.

Regarding di(meth)acrylates of bifunctional epoxy compounds, examples of bifunctional epoxy compounds include diglycidyl ether of biphenol and bisphenol. Bisphenol includes those described above.

Examples of an alkylene oxide group in the molecular structure of polyalkylene glycol di(meth)acrylates include ethylene oxide, propylene oxide, and butylene oxide. Polyalkylene glycol di(meth)acrylates may have multiple types of alkylene oxide group per molecule, which may be a block type where the same alkylene oxide group is continuous, or a random type where multiple types of alkylene oxide group are connected at random. The total number of alkylene oxide groups per molecule may be 6 or more, 10 or more, or 12 or more. It may be 32 or less, 28 or less, or 24 or less. The total number of alkylene oxide groups per molecule of polyalkylene glycol di(meth)acrylates may be, for example, within a range from 6 to 32. When the number of alkylene oxide groups per molecule is not constant due to convenience of industrial production or the like, the average value may be within a range from 6 to 32.

Examples of urethane di(meth)acrylates include a urethanation reaction product of a hydroxyalkyl (meth)acrylate and a diisocyanate compound, and a (poly)alkylene oxide-modified compound thereof. Examples of the diisocyanate compound include hexamethylene diisocyanate, isophorone diisocyanate, and toluene diisocyanate.

Examples of a polyfunctional compound (B3) include a poly (meth)acrylate of a trifunctional or higher aliphatic polyol, and a (poly)alkylene oxide-modified compound thereof, and a poly(meth)acrylate of a trifunctional or higher epoxy compound, and a (poly)alkylene oxide-modified compound thereof.

Regarding the poly(meth)acrylate of a trifunctional or higher aliphatic polyol, examples of the trifunctional or higher aliphatic polyol include trimethylolethane, trimethylolpropane, glycerin, tetramethylolmethane, pentaerythritol, and dipentaerythritol. Specific examples of these poly(meth)acrylates include trimethylolpropane tri(meth)acrylates, tetramethylolmethane tetra(meth)acrylates, pentaerythritol tri (meth)acrylates, pentaerythritol tetra (meth)acrylates, dipentaerythritol penta(meth)acrylates, and dipentaerythritol hexa(meth)acrylates.

Regarding the (poly)alkylene oxide-modified compound in the compounds (B1), (B2), and (B3), examples of the alkylene oxide group include ethylene oxide, propylene oxide, and butylene oxide. The (poly)alkylene oxide-modified compound may have multiple types of alkylene oxide groups per molecule. The polyalkylene oxide group may be a block type where the same alkylene oxide group is continuous, or a random type where multiple types of alkylene oxide group are connected at random. **In** the (poly)alkylene oxide-modified compound, the total number of alkylene oxide groups per molecule may be within a range from 2 to 20. When the number of alkylene oxide groups per molecule is not constant due to the convenience of industrial production or the like, the average value may be within a range from 2 to 20.

In the photopolymerizable compound (B), it is preferable to include at least one selected from the group consisting of the bifunctional compound (B2) and the polyfunctional compound (B3), as this provides a photosensitive composition with high sensitivity and resolution. The proportion of the sum of the bifunctional compound (B2) and the polyfunctional compound (B3) relative to the whole photopolymerizable compound (B) may be, for example, 50% by mass or more, 70% by mass or more, 90% by mass or more, or 100% by mass.

It is preferable that the photopolymerizable compound (B) include the bifunctional compound (B2), as this provides a photosensitive composition with an excellent balance between sensitivity and resolution, and substrate adhesion. The proportion of the bifunctional compound (B2) relative to the whole photopolymerizable compound (B) may be, for example, 50% by mass or more, 70% by mass or more, 90% by mass or more, or 100% by mass.

In the bifunctional compound (B2), a (poly)alkylene oxide-modified compound of bisphenol di(meth)acrylates (hereinafter, sometimes called "bifunctional compound (B2-1)"), and a polyalkylene glycol di(meth)acrylate (hereinafter, sometimes called "bifunctional compound (B2-2)") are particularly preferable. The proportion of the sum of the bifunctional compound (B2-1) and the bifunctional compound (B2-2) relative to the whole photopolymerizable compound (B) may be, for example, 50% by mass or more, 70% by mass or more, 90% by mass or more, or 100% by mass.

The mass proportion of the bifunctional compound (B2-1) to the bifunctional compound (B2-2) may be such that the proportion of the bifunctional compound (B2-1) relative to the sum of both may be 50% by mass or more, 70% by mass or more, or 85% by mass or more. It may be 99.5% by mass or less, 99% by mass or less, or 97% by mass or less. The proportion of the bifunctional compound (B2-1) relative to the sum of the bifunctional compound (B2-1) and the bifunctional compound (B2-2) may be, for example, within a range from 50% to 99.5% by mass.

Examples of the bifunctional compound (B2-1) include compounds represented by general formula (6) below.

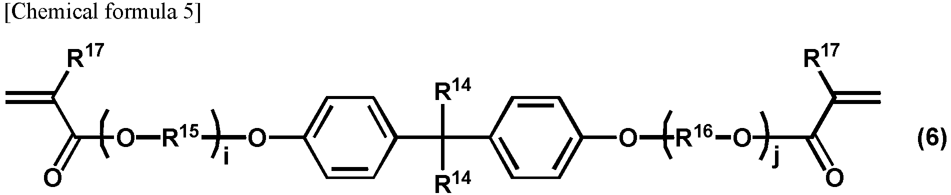

R¹⁴ in general formula (6) is each independently any one of a hydrogen atom, a methyl group, an ethyl group, or a phenyl group. R¹⁵ and R¹⁶ are each independently an alkylene group having 2 to 4 carbon atoms. R¹⁷ is each independently a hydrogen atom or a methyl group. i and j are each an integer of 1 or more.

R¹⁵ and R¹⁶ in general formula (6) are each independently an alkylene group having 2 to 4 carbon atoms, specifically, any one of an ethylene group, a propylene group, or a butylene group. When i and j are each 2 or more, multiple R¹⁵ and R¹⁶ groups present in the formula may all be different from each other, or may be partially or wholly the same.

In general formula (6), i and j are each an integer of 1 or more. i and j may be within a range from 1 to 12. When the number of alkylene oxide groups per molecule is not constant due to convenience of industrial production or the like, the average value may be within a range from 1 to 12. The sum of i and j may be within a range from 2 to 20. When the number of alkylene oxide groups per molecule is not constant due to convenience of industrial production or the like, the average value may be within a range from 2 to 20.

Multiple types of compounds having different total numbers of alkylene oxide groups per molecule may be used together as the bifunctional compound (B2-1). Specifically, in the bifunctional compound (B2-1), a compound having a total number of alkylene oxide groups per molecule (or an average value thereof) within a range from 2 to 6, and a compound having a total number of alkylene oxide groups per molecule (or an average value thereof) within a range from 8 to 14, may be used together. The mass proportion of the two may be such that the proportion of the compound having the number of alkylene oxide groups per molecule (or an average value thereof) within a range from 2 to 6 relative to the total mass of the two is 5% by mass or more, 10% by mass or more, or 15% by mass or more. It may be 55% by mass or less, 45% by mass or less, or 35% by mass or less. The value may be within a range from 5% to 55% by mass, for example.

Examples of the bifunctional compound (B2-2) include compounds represented by general formula (7) below.

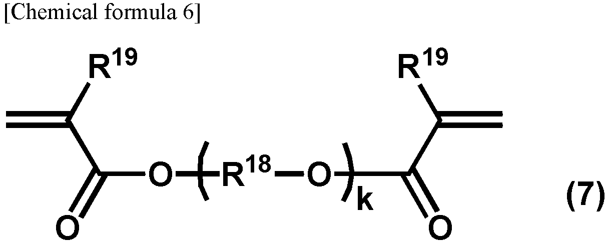

In formula (7), k is an integer of 2 or more. Multiple R¹⁸ groups present in the formula are each independently an alkylene group having 2 to 4 carbon atoms. R¹⁹ is each independently a hydrogen atom or a methyl group.]

In the general formula (7), k is an integer of 2 or more. k may be 6 or more, 10 or more, or 12 or more. It may be 32 or less, 28 or less, or 24 or less. The value of k may be within a range from 6 to 32, for example. When the number of alkylene oxide groups per molecule is not constant due to convenience of industrial production or the like, the average value may be within a range from 6 to 32.

Multiple R¹⁸ groups present in the formula are each independently an alkylene group having a carbon atom number of 2 to 4, specifically, any one of an ethylene group, a propylene group, or a butylene group. As described above, the bifunctional compound (B2-2) may have multiple types of alkylene oxide group per molecule, which may be a block type where the same alkylene oxide group is continuous, or a random type where multiple types of alkylene oxide group are connected at random. The bifunctional compound (B2-2) may be a compound represented by general formula (7-1) below, for example.

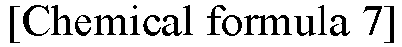

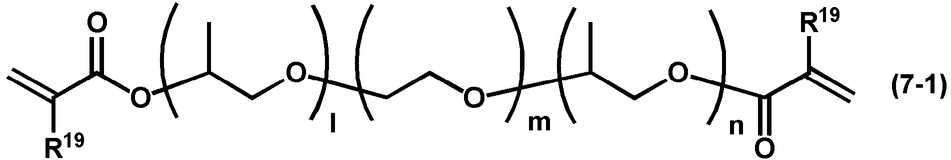

In general formula (7-1), l, m, and n are each independently an integer of 1 or more. R¹⁹ is each independently a hydrogen atom or a methyl group.

In general formula (7-1), l, m, and n are each independently an integer of 1 or more. Each of l, m, and n may be independently within a range from 2 to 20, for example. The sum of l and n may be within a range from 4 to 12, or 4 to 8. m may be within a range from 8 to 16. When the number of alkylene oxide groups per molecule is not constant due to convenience of industrial production or the like, each value may be an average value.

### [Hexaarylbiimidazole compounds (C1) and (C2)]

Regarding the hexaarylbiimidazole compound (C1), hexaarylbiimidazole is a compound having a biimidazole structure where two imidazole rings are bonded, wherein an aryl group is bonded to each of the carbon atoms at the 2-, 4-, and 5- positions of each imidazole ring.

In the hexaarylbiimidazole compound (C1), the two imidazole rings can be bonded via a nitrogen atom at the 1-position, and a carbon atom at the 2-position, for example. Specifically, the nitrogen atoms at the 1-positions of both imidazole rings may be bonded to each other, or the nitrogen atom at the 1-position of one imidazole ring may be bonded to the carbon atom at the 2-position of the other imidazole ring.

As long as the hexaarylbiimidazole compound (C1) includes no halogen atom in its molecular structure, other specific structures are not particularly limited. In particular, it is preferable to have an alkoxy group in its molecular structure, as this provides a photosensitive composition with high photosensitivity and excellent resolution when used as a resist material. The number of alkoxy groups per molecule is not particularly limited, but may be 6 or less, or 3 or less, for example.

A substituted position of an alkoxy group on each aryl group is not particularly limited, and may be any one of the ortho position, meta position, or para position relative to a bonding position with an imidazole ring. Thereamong, it is preferable that the alkoxy group be substituted at the ortho position relative to the bonding position with the imidazole ring, as this provides the hexaarylbiimidazole compound (C1) with excellent solvent solubility.

The number of carbon atoms of the alkoxy group in the hexaarylbiimidazole compound (C1) is preferably within a range from 2 to 10, as this provides the photosensitive composition with further excellent photosensitivity and resolution, and the hexaarylbiimidazole compound (C1) with excellent solvent solubility. Furthermore, it is more preferably within a range from 3 to 8, as this provides a more excellent balance between photosensitivity and resolution of the photosensitive composition, and solvent solubility of the hexaarylbiimidazole compound (C1). A carbon chain of the alkoxy group may be a straight chain type, or may have a branched structure. In particular, the straight chain type is preferable as this provides the hexaarylbiimidazole compound (C1) with excellent solvent solubility. Specific examples of the alkoxy group include an n-propyloxy group, an n-butyloxy group, an n-pentyloxy group, an n-hexyloxy group, an n-heptyloxy group, and an n-octyloxy group.

**In** an embodiment of the present disclosure, a photosensitive composition includes the hexaarylbiimidazole compound (C2) represented by general formula (1) below.

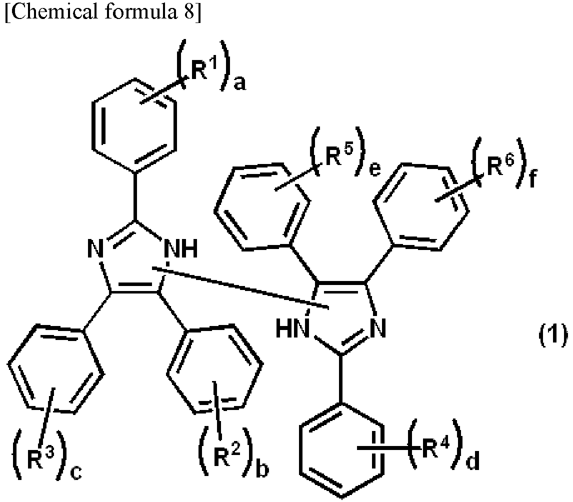

In general formula (1), R¹ to R⁶ are each independently an alkyl group or an alkoxy group, and a to f are each independently an integer from 0 to 5. When a to f are integers of 2 or more, multiple R^{X} groups (X is any one of 1 to 6) present in the formula may all be different from each other, or may be partially or entirely the same. At least one of a, b, c, d, e, or f is an integer of 1 or more, and at least one of R¹, R², R³, R⁴, R⁵, or R⁶ present in the formula is an alkoxy group.

In general formula (1), the two imidazole rings can be bonded by a nitrogen atom at the 1-position, and a carbon atom at the 2-position, for example. Specifically, the nitrogen atoms at positions 1 of both imidazole rings may be bonded to each other, or the nitrogen atom at the 1-position of one imidazole ring may be bonded to the carbon atom at the 2-position of the other imidazole ring. Note that the position numbers of imidazole rings are as follows.

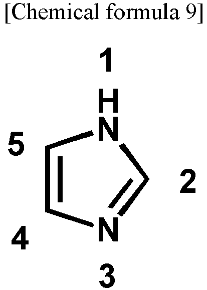

In general formula (1), R¹ to R⁶ are each independently an alkyl group or an alkoxy group. The number of carbon atoms of the alkyl group is preferably within a range from 2 to 10, as this provides the hexaarylbiimidazole compound (C2) with excellent solvent solubility. The alkyl group may be a straight chain type or may have a branched structure. In particular, the straight chain type is preferable as this provides the hexaarylbiimidazole compound (C2) with more excellent solvent solubility. Specific examples of the alkyl group include an n-propyl group, an n-butyl group, an n-pentyl group, an n-hexyl group, an n-heptyl, and an n-octyl group.

The number of carbon atoms of the alkoxy group is preferably within a range from 2 to 10, as this provides the hexaarylbiimidazole compound (C2) with excellent solvent solubility. Furthermore, it is more preferably within a range from 3 to 8 as this provides a more excellent balance between photosensitivity and resolution of the photosensitive composition, and solvent solubility of the hexaarylbiimidazole compound (C2). A carbon chain of the alkoxy group may be a linear chain type, or may have a branched structure. In particular, it is preferably a linear chain type as this provides the hexaarylbiimidazole compound (C2) with more excellent solvent solubility. Specific examples of the alkoxy group include an n-propyloxy group, an n-butyloxy group, an n-pentyloxy group, an n-hexyloxy group, an n-heptyloxy group, and an n-octyloxy group.

At least one of R¹, R², R³, R⁴, R⁵, or R⁶ present in general formula (1) is an alkoxy group. All of R¹ to R⁶ in formula (1) may be alkoxy groups. The number of alkoxy groups per molecule is not particularly limited, but may be 6 or less, or 3 or less, for example. In particular, it is preferably within a range from 1 to 3, and particularly preferably 2.

A substitution position of R¹ to R⁶ on each aryl group is not particularly limited, and may be any one of the ortho position, meta position, or para position relative to a bonding position with an imidazole ring. Thereamong, it is preferable that the R¹ to R⁶ be substituted at the ortho position relative to the bonding position with the imidazole ring, as this provides the hexaarylbiimidazole compound (C2) with excellent solvent solubility.

In general formula (1), a to f are each independently an integer from 0 to 5, respectively. In particular, a to f are each independently preferably 0 or 1, as this provides the hexaarylbiimidazole compound (C2) with excellent solvent solubility. Furthermore, it is more preferable that a and d be each 1, and b, c, e, and f be each 0. In this case, R¹ and R⁴, each of which is present once in the formula, are each preferably an alkoxy group.

The hexaarylbiimidazole compound (C2) may be a compound represented by general formula (1-1) below, for example.

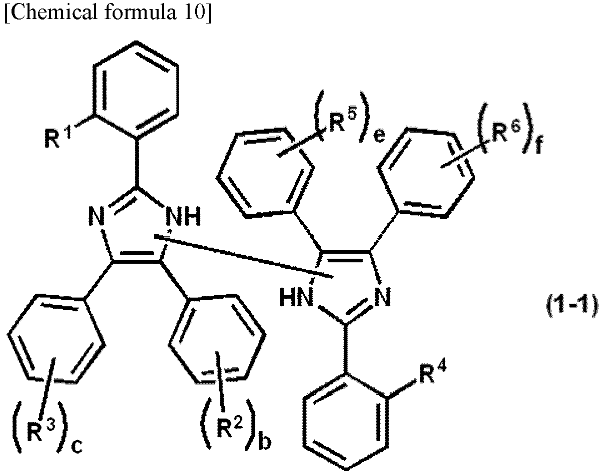

In general formula (1-1), R¹ to R⁶, b, c, e, and f are equivalent to those in general formula (1).

### [Photosensitive composition]

A photosensitive composition according to an embodiment includes the binder polymer (A), the photopolymerizable compound (B), and the hexaarylbiimidazole compound (C1) or the hexaarylbiimidazole compound (C2) (hereinafter these may be collectively referred to as hexaarylbiimidazole compound (C)).

The proportion of the binder polymer (A) to the photopolymerizable compound (B) can be appropriately adjusted according to desired photosensitivity, developability, resolution, or the like, when the photosensitive composition is used for a photosensitive element, for example. For example, the proportion of the binder polymer (A) relative to the total mass of the binder polymer (A) and the photopolymerizable compound (B) may be 15% by mass or more, 20% by mass or more, or 30% by mass or more. The proportion may be 60% by mass or less, 50% by mass or less, or 45% by mass or less. The proportion of the binder polymer (A) relative to the total mass of the binder polymer (A) and the photopolymerizable compound (B) may be 15% to 60% by mass, for example.

The amount of the hexaarylbiimidazole compound (C) added may be 0.1% by mass or more, 0.5% by mass or more, or 1% by mass or more, relative to the total mass of the binder polymer (A) and the photopolymerizable compound (B). It may be 15% by mass or less, 10% by mass or less, or 7% by mass or less. The amount of the hexaarylbiimidazole compound (C) added may be, for example, within a range from 0.1% to 15% by mass relative to the total mass of the binder polymer (A) and the photopolymerizable compound (B).

The photosensitive composition may include components other than the binder polymer (A), the photopolymerizable compound (B), and the hexaarylbiimidazole compound (C). Examples of the other components include another photopolymerization initiator (D) other than the hexaarylbiimidazole compound (C), a hydrogen donor (E), a photosensitizer (F), an organic solvent (G), an adhesion aid, a leveling agent, a polymerization inhibitor, a dye, a plasticizer, a defoaming agent, a flame retardant, and a peeling accelerator.

As for the other photopolymerization initiator (D) (hereinafter sometimes referred to as "photopolymerization initiator (D)"), although the hexaarylbiimidazole compound (C) is a component that generates a hydrogen abstraction-type radical upon irradiation with light and functions as a photopolymerization initiator, the photosensitive composition may further include the photopolymerization initiator (D). One type of the photopolymerization initiator (D) may be used singly, or two or more types thereof may be used in combination. Specific examples of the photopolymerization initiator (D) include: a benzophenone compound, a thioxanthone compound, a fluorenone compound, and an acridine compound which are hydrogen abstraction-type radical generators; and a benzyl ketal compound, an α-aminoalkylphenone compound, an α-hydroxyalkylphenone compound, an α-hydroxyacetophenone compound, and an acylphosphine oxide compound which are intramolecular cleavage-type radical generators.

The proportion of the hexaarylbiimidazole compound (C) relative to the total mass of the hexaarylbiimidazole compound (C) and the photopolymerization initiator (D) may be 50% by mass or more, 70% by mass or more, 90% by mass or more, or 100% by mass, for example. The total amount added of the hexaarylbiimidazole compound (C) and the photopolymerization initiator (D) may be 0.1% by mass or more, 0.5% by mass or more, or 1% by mass or more, relative to the total mass of the binder polymer (A) and the photopolymerizable compound (B). It may be 15% by mass or less, 10% by mass or less, or 7% by mass or less. The total amount added of the hexaarylbiimidazole compound (C) and the photopolymerization initiator (D) may be, for example, within a range from 0.1% to 15% by mass relative to the total mass of the binder polymer (A) and the photopolymerizable compound (B).

The hydrogen donor (E) is a component capable of donating hydrogen to a hydrogen abstraction-type radical generator such as the hexaarylbiimidazole compound (C), and allowing the newly generated radical to function as a polymerization initiator. One type of the hydrogen donor (E) may be used singly, or two or more types thereof may be used in combination. Specific examples of the hydrogen donor (E) include bis[4- (dimethylamino)phenyl] methane, bis[4-(diethylamino)phenyl] methane, and tris[4-(dimethylamino)phenyl] methane (also called leucocrystal violet). Thereamong, tris[4-(dimethylamino)phenyl] methane is preferable. The amount added of the hydrogen donor (E) added may be 0.05% by mass or more, 0.1% by mass or more, or 0.3% by mass or more, relative to the total mass of the binder polymer (A) and the photopolymerizable compound (B). It may be 5% by mass or less, 3% by mass or less, or 1% by mass or less. The amount added of the hydrogen donor (E) may be, for example, within a range from 0.05% to 5% by mass relative to the total mass of the binder polymer (A) and the photopolymerizable compound (B).

Examples of the photosensitizer (F) include an anthracene compound, a benzophenone compound, a pyrazoline compound, a coumarin compound, a xanthone compound, a thioxanthone compound, an oxazole compound, a benzoxazole compound, a thiazole compound, a benzothiazole compound, a triazole compound, a triazine compound, a thiophene compound, a naphthalimide compound, a triarylamine compound, and an aminoacridine compound. The amount added of the photosensitizer (F) may be 0.005% by mass or more, 0.01% by mass or more, or 0.05% by mass or more, relative to the total mass of the binder polymer (A) and the photopolymerizable compound (B). It may be 5% by mass or less, 3% by mass or less, or 1% by mass or less. The amount added of the photosensitizer (F) may be, for example, within a range from 0.005 % to 5% by mass relative to the total mass of the binder polymer (A) and the photopolymerizable compound (B).

The organic solvent (G) is a component mainly used for adjusting viscosity or the like of the photosensitive composition, improving workability in manufacturing the photosensitive element, and the like. One type of the organic solvent (G) may be used singly, or two or more types thereof may be used in combination. The proportion of the organic solvent (G) in the photosensitive composition is appropriately adjusted according to a desired viscosity, a desired film thickness of a photosensitive composition layer in the photosensitive element, or the like, and may be 20% by mass or more, 30% by mass or more, or 40% by mass or more, for example. It may be 90% by mass or less, 80% by mass or less, or 70% by mass or less, for example. The proportion of the organic solvent (G) in the photosensitive composition may be within a range from 20% to 90% by mass, for example.

Specific examples of the organic solvent (G) include: aromatic hydrocarbons such as toluene, xylene, mesitylene, cumene, and p-cymene; aliphatic hydrocarbons such as hexane and heptane; cyclic alkanes such as methylcyclohexane; cyclic ethers such as tetrahydrofuran and 1,4-dioxane; alcohol such as methanol and ethanol; ketones such as acetone, methyl ethyl ketone, methyl isobutyl ketone, cyclopentanone, cyclohexanone, and 4-hydroxy-4-methyl-2-pentanone; esters such as methyl acetate, ethyl acetate, butyl acetate, methyl lactate, ethyl lactate, and γ-butyrolactone; glycol ethers such as ethylene glycol monomethyl ether, ethylene glycol dimethyl ether, propylene glycol monomethyl ether, and propylene glycol dimethyl ether; glycol ether acetate such as propylene glycol 1-monomethyl ether 2-acetate; carbonic esters such as ethylene carbonate and propylene carbonate; and amides such as N,N-dimethylformamide, N,N-dimethylacetamide, and N-methyl-2-pyrrolidone (NMP). One type of these may be used singly, or two or more types thereof may be used in combination. As described above, in the hexaarylbiimidazole compounds (C), those having an alkoxy group in the molecular structure have excellent solvent solubility, and exhibit high solubility even when an aromatic hydrocarbon such as toluene, or a ketone such as cyclopentanone is used as the organic solvent (G).

The photosensitive composition may be used as a liquid negative resist material, in addition to being used as a dry film-type photosensitive element.

### [Photosensitive element]

A photosensitive element according to an embodiment includes a support, and a photosensitive composition layer that includes a photosensitive composition and is formed on the support. Examples of the support include a support film such as a polyester film such as polyethylene terephthalate, a polyolefin film such as polypropylene and polyethylene; a semiconductor wafer such as a silicon wafer, a sapphire wafer, and a compound semiconductor wafer. The thickness of the support film may be, for example, within a range from 1 to 100 µm. The thickness of the semiconductor wafer may be, for example, within a range from 0.1 to 2 mm.

The photosensitive composition layer includes the photosensitive composition. The photosensitive composition layer can be formed, for example, using a method of applying the photosensitive composition with a desired thickness on the support. When the photosensitive composition includes the organic solvent (G), it is preferable to volatilize the organic solvent (G) such that the content of the organic solvent (G) in the photosensitive composition layer is 2% by mass or less. A drying temperature at the time may be, for example, within a range from 70°C to 150°C. Drying time may be within a range from 5 to 30 minutes. The photosensitive composition can be applied using a roll coater, a comma coater, a gravure coater, an air knife coater, a die coater, or a bar coater, for example. The thickness of the photosensitive composition layer may be, for example, within a range from 1 to 100 µm, although a preferable value depends on intended use of the photosensitive element.

The photosensitive element may further have a protective film on the surface of the photosensitive composition layer. Examples of the protective film include a polyester film such as polyethylene terephthalate, and a polyolefin film such as polypropylene and polyethylene. The thickness of the protective film may be within a range from 1 to 100 µm, for example.

The photosensitive element may have an intermediate lamination between the support and the photosensitive composition layer. Examples of the intermediate lamination include a layer including a water-soluble resin such as a polyvinyl alcohol resin, an adhesive layer, a light absorbing layer, and a gas barrier layer.

When the support is a support film, the photosensitive element may have a sheet form, or a form wound into a roll shape. When the photosensitive element is wound in a roll shape, it may be wound such that the support film is on the outside.

### [Method of forming resist pattern]

A method of forming a resist pattern according to an embodiment includes a laminating step of laminating a photosensitive composition layer including a photosensitive composition on a circuit forming substrate, an exposing step of irradiating a predetermined portion of the photosensitive composition layer with an actinic ray to cure an exposed portion, and a developing step of removing a portion of the photosensitive composition layer other than the exposed portion from the circuit forming substrate, where the photosensitive composition layer has been laminated.

An example of the circuit forming substrate includes a substrate provided with an insulating layer and a conductor layer formed on the insulating layer, a metal base material for manufacturing a metal mask, and a die pad (lead frame base material) such as an alloy base material. The circuit forming substrate may be multilayered with wiring formed therein, and may have a small-diameter through hole.

The laminating step is a step of laminating a photosensitive composition layer on a circuit forming substrate. The photosensitive composition layer may be laminated using a method of applying the photosensitive composition directly on the circuit forming substrate and drying the organic solvent (G) as necessary. Alternatively, lamination may be performed using a method where a photosensitive element having a support film as the support is used, and the photosensitive composition layer of the photosensitive element is pressed onto the circuit-forming substrate while being heated. When the photosensitive element has a protective film, the protective film is removed and then the photosensitive composition layer is heated and pressed. When a photosensitive element having a support film is used as a support, it is preferable to perform the laminating step under a reduced pressure from the viewpoint of adhesion and followability. The heating temperature at the time of pressing may be within a range from 70°C to 130°C. In order to further improve laminability of the photosensitive composition layer, preheating of the circuit forming substrate may be performed. The pressure at the time of pressing may be, for example, within a range from 0.1 to 1.0 MPa (1 to 10 kgf/cm²).

Examples of the exposing step include a method of irradiating an actinic ray through a pattern called an artwork (mask exposure method), a projection exposure method, a laser direct writing exposure method, and a DLP exposure method. When a photosensitive element where a support is a support film is used in the laminating step, the actinic ray can be irradiated through the support film when the support film present on the photosensitive composition layer transmits an actinic ray, and the photosensitive composition layer is irradiated with the actinic ray after the support film is removed when the support film is light-shielding.

As the light source of the actinic ray, a known light source may be used, and examples include light sources that effectively emit ultraviolet rays, visible light, or the like, such as a carbon arc lamp, a mercury vapor arc lamp, a high-pressure mercury lamp, a xenon lamp, a gas laser such as an argon laser, a solid laser such as a YAG laser, and a semiconductor laser. The wavelength of the actinic ray may be within a range from 340 to 430 nm.

In the developing step, if a support film is present on the photosensitive composition layer, the developing step is performed after the support film is removed. The development method is roughly divided into wet development and dry development, and wet development is widely used.

Examples of a developer used in wet development include an alkaline aqueous solution, an aqueous developer, and an organic solvent-based developer, and a developer corresponding to the photosensitive composition is selected and used. The development can be performed using, for example, a known method, such as a dip method, a paddle method, a spray method, rocking dipping, brushing, or scrapping. From the viewpoint of improving resolution, a high-pressure spray method is preferably used. Two or more types of development methods may be used in combination as necessary.

Examples of the alkaline aqueous solution include aqueous solutions of: alkali hydroxides such as hydroxides of lithium, sodium, or potassium; alkali carbonates such as carbonates and bicarbonates of lithium, sodium, potassium, or ammonium; alkali metal phosphates such as potassium phosphates and sodium phosphates; alkali metal pyrophosphates such as sodium pyrophosphates and potassium pyrophosphates; borax; sodium metasilicate; tetramethylammonium hydroxide; ethanolamine; ethylenediamines; diethylenetriamine; 2-amino-2-hydroxymethyl-1,3-propanediol; 1,3-diaminopropanol-2; and morpholine.

Preferable examples of the alkaline aqueous solution include a dilute solution of 0.1% to 5% by mass sodium carbonate, a dilute solution of 0.1% to 5% by mass potassium carbonate, a dilute solution of 0.1% to 5% by mass sodium hydroxide, and a dilute solution of 0.1% to 5% by mass sodium tetraborate (borax). pH of the alkaline aqueous solution is preferably within a range from 9 to 11. Temperature of the alkaline aqueous solution may be adjusted according to developability of the photosensitive composition layer. A surfactant, a defoaming agent, a small amount of an organic solvent for promoting development, or the like may be added to the alkaline aqueous solution.

Examples of the organic solvent-based developer include 1,1,1-trichloroethane, N-methylpyrrolidone, N,N-dimethylformamide, cyclohexanone, methyl isobutyl ketone, and γ-butyrolactone. To these organic solvent-based developers, it is preferable to add water within a range from 1% to 20% by mass to prevent ignition.

After the developing process, the resist pattern may be further cured by heating or exposure as necessary. The heating temperature may be within a range from 60°C to 250°C. Light intensity during exposure may be within a range from 0.2 to 10 J/cm².

### [Method of manufacturing printed circuit board]

A method of manufacturing a printed circuit board according to an embodiment includes a step of forming a conductor pattern by etching or plating a circuit forming substrate where a resist pattern is formed using the resist pattern forming method described above.

The etching and plating of the circuit forming substrate are performed on the conductor layer of the circuit forming substrate using the formed resist pattern as a mask. Examples of the etching solution include a cupric chloride solution, a ferric chloride solution, an alkaline etching solution, and a hydrogen peroxide etching solution. Examples of the plating method include: copper plating such as copper sulfate plating and copper pyrophosphate plating; solder plating such as high slow solder plating, Watt bath (nickel sulfate-nickel chloride) plating; nickel plating such as nickel sulfamate, and gold plating such as hard gold plating and soft gold plating.

After the conductor pattern is formed using etching or plating, the resist pattern on the substrate may be removed. The resist pattern can be removed by peeling using an aqueous solution having stronger alkalinity than that of the alkaline aqueous solution used for development, for example. Examples of the strong alkaline aqueous solution include 1% to 10% by mass aqueous sodium hydroxide solution, and 1% to 10% by mass aqueous potassium hydroxide solution. Examples of the peeling method include a dipping method and a spray method, which may be used alone or in combination. When the resist pattern is removed after plating, the conductor layer which has been covered with the resist pattern may be further etched to form the conductor pattern.

Examples of embodiments will be described below. The present invention is not limited to the following embodiments.
<1> A photosensitive composition including the binder polymer (A), the photopolymerizable compound (B), and the hexaarylbiimidazole compound (C1) including no halogen atom in its molecular structure.
<2> The photosensitive composition according to <1>, wherein the hexaarylbiimidazole compound (C1) has an alkoxy group in its molecular structure.
<3> The photosensitive composition according to <1> or <2>, wherein the number of carbon atoms of the alkoxy group is within a range from 2 to 8.
<4> A photosensitive composition including the binder polymer (A), the photopolymerizable compound (B), and the hexaarylbiimidazole compound (C2) represented by general formula (1) below.

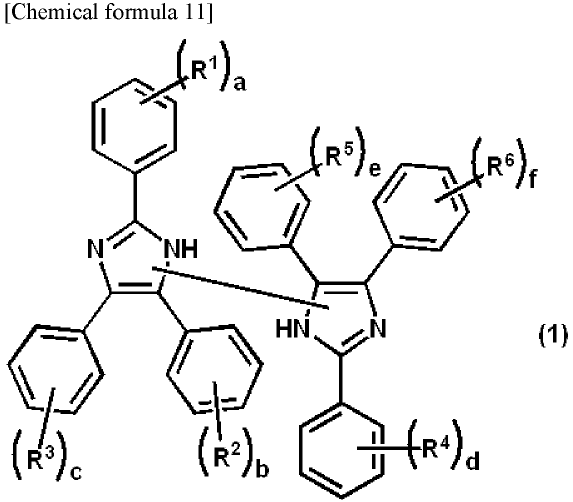

In general formula (1), R¹ to R⁶ are each independently an alkyl group or an alkoxy group, and a to f are each independently an integer from 0 to 5. When a to f are integers of 2 or more, multiple R^{X} groups (X is any one of 1 to 6) in the formula may all be different from each other, or may be partially or entirely the same. At least one of a, b, c, d, or f is an integer of 1 or more, and at least one of R¹, R², R³, R⁴, R⁵, or R⁶ present in the formula is an alkoxy group.
<5> The photosensitive composition according to any one of <1> to <4>, further including toluene as an organic solvent.
<6> The photosensitive composition according to any one of <1> to <5>, further including cyclopentanone as an organic solvent.
<7> A photosensitive element including a support, and a photosensitive composition layer including the photosensitive composition described in any one of <1> to <6> and formed on the support.
<8> A method of forming a resist pattern, including a laminating step of laminating a photosensitive composition layer including the photosensitive composition described in any one of <1> to <6> on a circuit forming substrate, an exposing step of irradiating a predetermined portion of the photosensitive composition layer with an actinic ray to cure an exposed portion, and a developing step of removing a portion of the photosensitive composition layer other than the exposed portion from the circuit forming substrate, where the photosensitive composition layer has been laminated.
<9> A method of manufacturing a printed circuit board, including a step of etching or plating a circuit forming substrate where a resist pattern is formed using the resist pattern forming method according to <8> to form a conductor pattern.

### [Examples]

Hereinafter, the present invention will be described more specifically with reference to examples, but the present invention is not limited to the following examples.

### Method of measuring weight-average molecular weight (Mw) and number-average molecular weight (Mn)

Weight-average molecular weight and number-average molecular weight were obtained using gel permeation chromatography (GPC) and converted from a calibration curve using standard polystyrene. GPC conditions are as follows.

| | |
|---|---|
| Detector: | L-2490 type RI (Hitachi High-Tech Corporation) |
| Columns: | Gelpack GL-R440, Gelpack GL-R450, and Gelpack GL-R400M (Resonac Techno Service Corporation) |
| Eluent: | tetrahydrofuran |
| Sample concentration: | 5 mg / 1 mL |
| Injection volume: | 200 µL |
| Flow rate: | 2.05 mL/min |

### Example 1 to 5 and comparative example 1

### [Production of photosensitive composition]

A photosensitive composition was produced by blending and mixing the components in the proportions listed in Table 1 below. Details of the components in Table 1 are as follows.

Binder polymer (A-1): 47% by mass solution of an acrylic resin prepared using styrene 45% by mass, benzyl methacrylate 23% by mass, methacrylic acid 27% by mass, and methyl methacrylate 5% by mass. The solvent is methyl propylene glycol/toluene, and the weight-average molecular weight (Mw) of the acrylic resin is 51,000.

Photopolymerizable compound (B-1): "FA-321M" manufactured by Resonac Corporation, polyethylene oxide-modified compound of bisphenol A di(meth)acrylate, the average total number of ethylene oxide groups per molecule is 10.

Photopolymerizable compound (B-2): "NK ester BPE-200" manufactured by SHIN-NAKAMURA CHEMICAL CO, LTD., a polyethylene oxide-modified compound of bisphenol A di(meth)acrylate, the average value of the total number of ethylene oxide groups per molecule is 4.

Photopolymerizable compound (B-3): "FA-024M" manufactured by Resonac Corporation, a polyalkylene glycol di(meth)acrylate represented by general formula (7-2) below, the average value of the sum of 1 and n is 6, and the average value of m is 12.

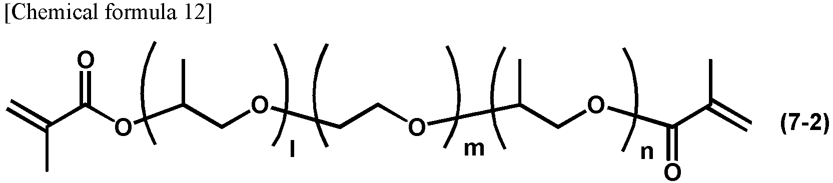

Hexaarylbiimidazole compound (C-1): compound where R²⁰ is an n-propyloxy group in general formula (1-2) below
Hexaarylbiimidazole compound (C-2): compound where R²⁰ is an n-butyloxy group in general formula (1-2) below
Hexaarylbiimidazole compound (C-3): compound where R²⁰ is an n-pentyloxy group in general formula (1-2) below
Hexaarylbiimidazole compound (C-4): compound where R²⁰ is an n-hexyloxy group in general formula (1-2) below
Hexaarylbiimidazole compound (C-5): compound where R²⁰ is an n-octyloxy group in general formula (1-2) below
Hexaarylbiimidazole compound for comparison: A compound in which R²⁰ is a chloro group in general formula (1-2) below

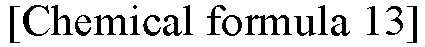

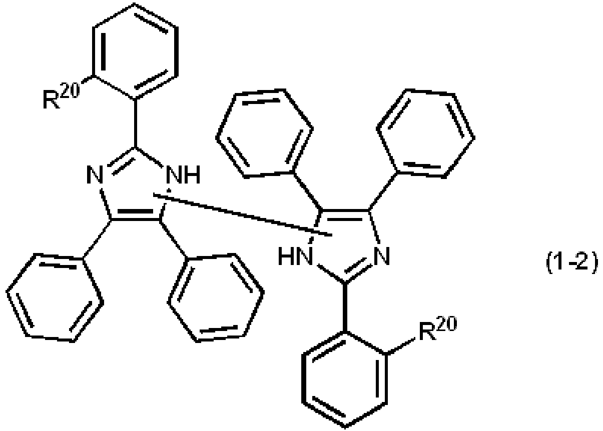

Hydrogen donor: Leucocrystal violet (tris[4-(dimethylamino)phenyl] methane) manufactured by YAMADA CHEMICAL CO., LTD.
Sensitizer: 9,10-dibutoxyanthracene manufactured by KAWASAKI KASEI CHEMICALS LTD.
Adhesive agent: "XIAMETER OFS-6030 Silane" manufactured by The Dow Chemical Company, methacryloxypropyltrimethoxysilane
Leveling agent: "DOWSIL 8032 Additive" manufactured by The Dow Chemical Company, polyether-modified silicone
Polymerization inhibitor: "TBC-5P" manufactured by DIC Corporation, tertiary butylcatechol

**[Table 1]**

| Table 1 Compositional formulation of photosensitive composition | | | | | | | |
|---|---|---|---|---|---|---|---|
| | | Example 1 | Example 2 | Example 3 | Example 4 | Example 5 | Comparative example 1 |
| Binder polymer (A-1) solution | [parts by mass] | 57 | 57 | 57 | 57 | 57 | 57 |
| Photopolymerizable compound(B-1) | [parts by mass] | 30.5 | 30.5 | 30.5 | 30.5 | 30.5 | 30.5 |
| Photopolymerizable compound(B-2) | [parts by mass] | 10 | 10 | 10 | 10 | 10 | 10 |
| Photopolymerizable compound(B-3) | [parts by mass] | 2.5 | 2.5 | 2.5 | 2.5 | 2.5 | 2.5 |
| Hexaarylbiimidazole compound(C-1) | [parts by mass] | 2.9 | | | | | |
| Hexaarylbiimidazole compound(C-2) | [parts by mass] | | 2.9 | | | | |
| Hexaarylbiimidazole compound(C-3) | [parts by mass] | | | 2.9 | | | |
| Hexaarylbiimidazole compound(C-4) | [parts by mass] | | | | 2.9 | | |
| Hexaarylbiimidazole compound(C-5) | [parts by mass] | | | | | 2.9 | |
| Hexaarylbiimidazole compound for comparison | [parts by mass] | | | | | | 2.9 |
| Hydrogen donor | [parts by mass] | 0.5 | 0.5 | 0.5 | 0.5 | 0.5 | 0.5 |
| Sensitizer | [parts by mass] | 0.2 | 0.2 | 0.2 | 0.2 | 0.2 | 0.2 |
| Adhesive agent | [parts by mass] | 1 | 1 | 1 | 1 | 1 | 1 |
| Leveling agent | [parts by mass] | 0.07 | 0.07 | 0.07 | 0.07 | 0.07 | 0.07 |
| Polymerization inhibitor | [parts by mass] | 0.05 | 0.05 | 0.05 | 0.05 | 0.05 | 0.05 |
| Solvent: cyclopentanone | [parts by mass] | 90 | 90 | 90 | 90 | 90 | 90 |

### [Manufacture of photosensitive element]

The photosensitive composition obtained above was coated on a support (*1). It was dried in a hot air convection dryer at 90°C for 5 minutes, and a photosensitive composition layer having a film thickness of about 6 µm after drying was formed. Subsequently, a PET film (*2) as a protective layer was pressed on the photosensitive composition layer using a heat roll at 110°C to obtain a laminated body. The pressure bonding was performed under conditions of a pressure of 0.4 MPa and a roll speed of 1.0 m/min.

Support (*1): "6 inch bare wafer" manufactured by ADVANTEC CO. LTD., silicon wafer having a thickness of about 610 µm
PET film (*2): "FB-40" manufactured by Toray Industries, Inc.

### [Evaluation of photosensitive composition]

Phototools 1 (linear type) and 2 (spatial type) of glass chrome type were each used to expose the photosensitive composition layer by irradiating an actinic energy ray through the PET film of the photosensitive element. After exposure, the PET film was peeled off to expose the photosensitive composition layer, and development was performed using a 1% by mass sodium carbonate aqueous solution at 30°C.

The irradiation amount of the actinic energy ray was increased by 10 mJ/cm² from 110 mJ/cm², and the resolution was defined as the minimum value of x at which a clear resist pattern could be obtained at each irradiation amount.

The relationship between the exposure amount (mJ/cm²) and the resolution (µm) was plotted on xy coordinates for each case of using phototools 1 (liniar type) and using phototools 2 (spacial type), and the intersection of the approximate curves was defined as an intersection exposure amount.

Table 2 illustrates the intersection exposure amount and the resolution at the time of irradiation with the intersection exposure amount for each example and comparative example.

The photosensitive composition has better photosensitivity, resolution, and developability as the intersection exposure amount is smaller and the resolution value is smaller.

Phototools 1 (line type): line width / space width = x/4x, where x is 1 µm to 10 µm in increments of 1 µm
Phototools 2 (space type): line width / space width = 4x/x, where x is 1 µm to 10 µm in increments of 1 µm

Actinic energy ray irradiation conditions: "FPA-3000iw" manufactured by Canon Inc., a projection exposure apparatus, using an ultrahigh-pressure mercury lamp (365 nm) as a light source was used. The focus position was set at a depth of 19 µm from the surface of the supporting film (corresponding to approximately the middle of the film thickness of the photosensitive composition layer).

**[Table 2]**

| Table 2 Evaluation of photosensitive composition | | | | | | | |
|---|---|---|---|---|---|---|---|
| | | Example 1 | Example 2 | Example 3 | Example 4 | Example 5 | Comparative example 1 |
| Intersection exposure amount | [mJ/cm²] | 160 | 200 | 220 | 220 | 240 | 320 |
| Resolution of phototools 1 (linear type) | [µm] | 3 | 3 | 4 | 3 | 4 | 5 |
| Resolution of phototools 2 (spacial type) | [µm] | 3 | 3 | 3 | 3 | 4 | 5 |

As illustrated in Table 2, compared with the photosensitive composition of comparative example 1, the photosensitive compositions of examples 1 to 5 have a smaller intersectional exposure amount and a smaller resolution value, and thus it can be said to be excellent in photosensitivity, resolution, and developability.

### [Solvent solubility evaluation of photosensitive compositions]

For the photosensitive compositions of examples 1 to 5, 90 g of cyclopentanone was replaced with 90 g of the following two mixed solvents, and each mixture was stirred to evaluate solubility. Examples with the components completely dissolved were classified as A, and those with undissolved residues remained were classified as A. The results are listed in Table 3.
Mixed solvent 1: acetone / toluene / methanol in a mass ratio of 5/9/5
Mixed solvent 2: acetone / cyclopentanone / methanol in a mass ratio of 5/9/5

**[Table 3]**

| Table 3 Solvent solubility evaluation of photosensitive composition | | | | | |
|---|---|---|---|---|---|
| photosensitive composition | Example 1 | Example 2 | Example 3 | Example 4 | Example 5 |
| Mixed solvent 1 | A | A | A | A | A |
| Mixed solvent 2 | A | B | B | A | A |

## Claims

1. A photosensitive composition comprising:
a binder polymer (A);
a photopolymerizable compound (B); and
a hexaarylbiimidazole compound (C1) having no halogen atom in its molecular structure.

2. The photosensitive composition according to claim 1, wherein
the hexaarylbiimidazole compound (C1) has an alkoxy group in its molecular structure.

3. The photosensitive composition according to claim 2, wherein
the number of carbon atoms in the alkoxy group is within a range from 2 to 10.

4. A photosensitive composition comprising:
a binder polymer (A);
a photopolymerizable compound (B); and
a hexaarylbiimidazole compound (C2) represented by general formula (1) below 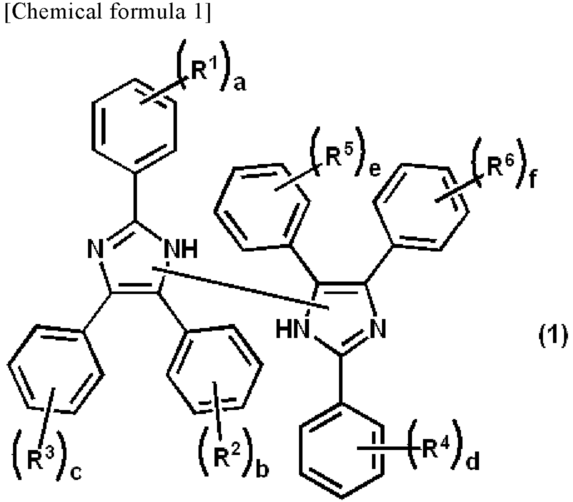
where R¹ to R⁶ are each independently an alkyl group or an alkoxy group, and a to f are each independently an integer from 0 to 5 wherein
when a to f are integers of 2 or more, a plurality of R^{X} groups (X is any one of 1 to 6) in the formula may all be different from each other, or may be partially or entirely the same, and
at least one of a, b, c, d, or f is an integer of 1 or more, and at least one of R', R², R³, R⁴, R⁵, or R⁶ present in the formula is an alkoxy group.

5. The photosensitive composition according to any one of claims 1 to 4, further comprising:
toluene as an organic solvent.

6. The photosensitive composition according to any one of claims 1 to 4, further comprising:
cyclopentanone as an organic solvent.

7. A photosensitive element comprising:
a support; and
a photosensitive composition layer including the photosensitive composition according to any one of claims 1 to 4 formed on the support.

8. A method of forming a resist pattern comprising:
a laminating step of laminating a photosensitive composition layer including the photosensitive composition according to any one of claims 1 to 4 on a circuit forming substrate;
an exposing step of irradiating a predetermined portion of the photosensitive composition layer with an actinic ray to cure an exposed portion; and
a developing step of removing a portion of the photosensitive composition layer other than the exposed portion from the circuit forming substrate, where the photosensitive composition layer has been laminated.

9. A method of manufacturing a printed circuit board, comprising:
a step of forming a conductor pattern by etching or plating a circuit forming substrate where a resist pattern is formed using the resist pattern forming method according to claim 8.
